(19) Europäisches Patentamt

European Patent Office

Office européen des brevets

(11) **EP 0 683 515 B1**

(12) **EUROPEAN PATENT SPECIFICATION**

(45) Date of publication and mention
of the grant of the patent:
**16.08.2001 Bulletin 2001/33**

(51) Int Cl.[7]: **H01L 21/8238**, H01L 27/092

(21) Application number: **95303278.6**

(22) Date of filing: **17.05.1995**

(54) **Method of manufacturing a CMOS device**

Verfahren zur Herstellung einer CMOS Vorrichtung

Procédé de réalisation d'un dispositif CMOS

(84) Designated Contracting States:
**DE FR GB IT**

(30) Priority: **17.05.1994 KR 9410776**

(43) Date of publication of application:
**22.11.1995 Bulletin 1995/47**

(73) Proprietor: **Samsung Electronics Co., Ltd.**
**Suwon-city, Kyungki-do 441-370 (KR)**

(72) Inventors:
• **Kim, Dong-jun,**
**2-1410, Samsung Woncheon 1-cha Apt.**
**Suwon-city, Kyungki-do (KR)**
• **Choi, Jeong-hyuk**
**Seocho-gu, Seoul (KR)**

(74) Representative: **Ertl, Nicholas Justin et al**
**Elkington and Fife,**
**Prospect House,**
**8 Pembroke Road**
**Sevenoaks, Kent TN13 1XR (GB)**

(56) References cited:
**EP-A- 0 336 977**        **EP-A- 0 358 246**
**US-A- 5 024 961**        **US-A- 5 105 252**

• **PATENT ABSTRACTS OF JAPAN vol. 11, no. 88 (E-490) (2535) 18 March 1987 & JP-A-61 242 064 (TOSHIBA CORP) 20 October 1986**
• **PATENT ABSTRACTS OF JAPAN vol. 2, no. 65 (E-34) 18 May 1978 & JP-A-53 031 978 (NIPPON DENKI K.K.) 25 March 1978**
• **PATENT ABSTRACTS OF JAPAN vol. 17, no. 484 (E-1426) 2 September 1993 & JP-A-05 121 683 (OLYMPUS OPTICAL CO LTD) 18 May 1993**
• **PATENT ABSTRACTS OF JAPAN vol. 17, no. 325 (E-1384) 21 June 1993 & JP-A-05 036 917 (SONY CORP) 12 February 1993**

## Description

The present invention relates to a semiconductor device and a method for manufacturing the same, and more particularly, to a CMOS which can improve punch-through characteristics of transistors formed on a well and substrate simultaneously, and a method for manufacturing the same.

A CMOS is produced by forming PMOS and NMOS transistors on a substrate and electrically connecting them. Conventionally, after forming an N-well and P-well in the semiconductor substrate, transistors having contrasting conductivities are formed simultaneously on the wells and on the semiconductor substrate between the wells, thereby forming the CMOS.

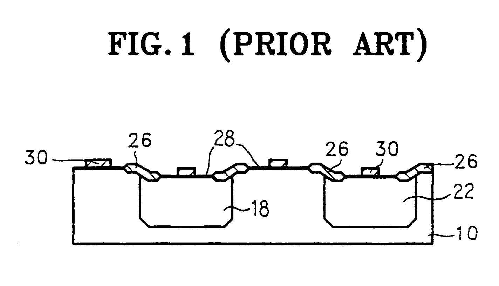

FIG. 1 of the accompanying drawings is a cross-sectional view of a CMOS manufactured by a conventional method, where reference numeral 10 is a semiconductor substrate, reference numeral 18 is an N-well, reference numeral 22 is a P-well, reference numeral 26 is a field oxide layer, reference numeral 28 is a gate oxide layer, and reference numeral 30 is a gate electrode.

The CMOS shown in FIG. 1 is formed by the steps of selectively doping impurities on P-type semiconductor substrate 10 to form an N-well 18 and P-well 22, performing a conventional field-oxide-layer manufacturing process to form a field oxide layer 26, forming a gate oxide layer 28 on the surface of each well and substrate, and forming a gate electrode 30 on the gate oxide layer.

As a semiconductor device becomes more highly integrated, the unit size of the devices decreases, thus reducing the electrical characteristics of each device proportionally. For example, in the case of a transistor, if the gap between source and drain is reduced to increase integration, the generation rate of punch-through due to contact between source and drain depletion regions becomes higher in proportion to the gap-size reduction.

The lower the impurity concentration of the substrate, the more frequently punch-through occurs. Here, the rate of punch-through generation becomes higher particularly in very small scale transistors. This is because a lower impurity concentration in the vicinity of the source and drain depletion regions and the substrate translates into larger source/drain depletion regions.

Recently, research into a method for increasing the punch-through voltage of a transistor by increasing the impurity concentration in the vicinity of the source and drain depletion regions has been actively carried out. U.S. Patent No. 4,354,307 (entitled: Method for mass producing miniature field effect transistors in high density LSI/VLSI chips; Inventor: Vinson et al.; Application No.: 99,515) teaches a method for increasing a transistor's punch-through voltage rating by selectively increasing the impurity concentration of a substrate. Here, however, since the bulk concentrations of the well and substrate which crucially influence electrical characteristics of transistors respectively formed on a well and substrate are not selectively adjusted for each transistor, it is difficult to adjust the different electric characteristics required for each transistor respectively formed on the well and substrate.

For example, if the transistor formed on the substrate requires a specific punch-through voltage and the transistor formed on the well requires a reduced back-bias at a given operating voltage, the transistor formed on the substrate should have a high punch-through voltage by increasing the bulk concentration of the depletion region. Further, as suggested by the following equation (1), the transistor formed on the well should have a low gamma ($\gamma$) value, which represents the variation of threshold voltages due to the back-biasing.

$$\gamma = \frac{(2\varepsilon_S \varepsilon_0 q N_a)^{\frac{1}{2}}}{C_{OX}} \qquad (1)$$

where $C_{OX}$ is the capacitance of a gate oxide layer, $\varepsilon_s$ is the dielectric constant of a semiconductor substrate, $\varepsilon_0$ is the dielectric constant of a vacuum, q is charge quantity, and $N_a$ is the number of impurities. As understood from the above equation (1), in order to lower the 7 value, the value of $qN_a$, i.e., bulk concentration, should be lowered. That is, when the transistor formed on the substrate requires a particular punch-through voltage and the transistor formed on the well requires reduced back biasing at an operating voltage, the bulk concentration on the well should be different from that on the substrate.

However, using the conventional technique in which the respective bulk concentrations are not independently adjusted, it is not possible to manufacture transistors sufficing both these characteristics at the same time. Therefore, in order to accomplish this independent adjustment of the bulk concentration, separate mask processes therefor should be performed.

EP-A-0 336 977 discloses a semiconductor device including a semiconductor substrate of a first conductivity type in which a shallow well of a second conductivity type is formed. The well is surrounded by a buried layer of a high concentration of the first conductivity type formed in a deep region beneath the well, and by a well of the first conductivity type in a shallow region formed continuously from the buried layer of high concentration first conductivity type semiconductor material, in a self aligned manner in the substrate.

JP-A-61 242 064 discloses a method of manufacture of a CMOS device including the step of simultaneously forming ion implantation layers at positions in the vicinity of the surface and at deep positions relative to the surface of a substrate.

US-A-5 105 252 discloses a semiconductor CMOS device having a low voltage BiCMOS and a high voltage BiCMOS on the same substrate.

EP-A-0 358 246 discloses a method of manufacture of a semiconductor device comprising a silicon body having a surface where there are situated a number of semiconductor regions and field oxide regions, the semiconductor regions being formed after the field oxide regions have been created by implantations of n-type and p-type dopants.

US-A-5 024 961 discloses a blanket boron implant that functions as both a punch-through and field-isolation implant for sub-micron N-channel CMOS devices.

JP-A-53 031 978 discloses a method for the production of a complimentary field effect semiconductor device by simultaneously forming two or more wells, each with different concentrations of dopants, by a single implantation and one heat treatment.

JP-A-05 121 683 discloses a CMOS semiconductor device in which a first conductivity type region whose impurity concentration is higher than that of a first conductivity type semiconductor region, is formed in a second conductivity type channel region of a MOS type field effect transistor.

JP-A-05 036 917 discloses a method of manufacture of a CMOS semiconductor device in which an impurity for forming a P-well and an impurity for forming an N-channel stopper are sequentially ion-implanted in an N-channel region, and an impurity for forming an N-well and an impurity for forming a P-channel stopper are sequentially ion implanted in a P-channel region. Boron is then ion-implanted which regulates a threshold value voltage of the device.

According to the present invention there is provided a method of manufacturing a CMOS device comprising the steps of, sequentially:

(a) forming a first insulating layer on a semiconductor substrate;

(b) removing said first insulating layer from a region for a first well to be formed thereon;

(c) doping impurities into said region to form the first well;

(d) forming a second insulating layer on the surface of the region from which said first insulating layer has been removed and completing the first well under said second insulating layer by performing a well drive-in process;

(e) removing said first insulating layer from a second region for a second well to be formed thereon;

(f) doping impurities into said second region to form said second well;

(g) forming a third insulating layer on the surface of the region from which said first insulating layer has been removed to form the second well, and completing the second well under said third insulating layer by performing a well drive-in process;

(h) removing either of said first insulating layer or said second and third insulating layers; and,

(i) forming a first impurity layer at a first depth in the region from which said insulating layer or layers is or are not removed by step (h) and a second impurity layer at a second depth larger than said first depth, in the region from which said insulating layer or layers is or are removed by step (h), by implanting impurities in the whole surface of the resultant structure,

(j) forming MOS transistors in the region from which said insulating layer or layers is or are not removed by step (h) and in the region from which said insulating layer or layers is or are removed by step (h), said first impurity region lying in the source/drain depletion regions of the transistors, thereby increasing the punch-through voltage thereof, said second impurity region lying under the source/drain depletion regions of the transistors, thereby not affecting the operating voltage thereof.

In an embodiment of the method for manufacturing a CMOS device according to the present invention, after the step (i), there is further provided a step of redoping impurities in the depth less than the first impurity layer on the whole surface of the resultant structure.

In the method for manufacturing the CMOS device according to the present invention, the concentration of the first and second impurity layers is preferably lower than that of the third impurity layer and is preferably higher than that of the semiconductor substrate and wells.

In the method for manufacturing the CMOS device according to the present invention, the first insulating layer is preferably formed in the thickness of 1,000Å~2,000Å and the second insulating layer is preferably formed in the thickness of 4,000Å~6,000Å, and at this time, the impurities are more preferably doped at the energy of 400keV~800keV.

In a preferred embodiment, the first well is an N-impurity-doped well and the second well is a P-impurity-doped well. Also, the second well may be formed within the first well.

In another preferred embodiment, the second well may be formed within the first well.

The characteristic feature of the present invention lies in that the bulk concentration outside the depletion region does not affect the $\gamma$ value. That is to say, if an impurity is doped below the depletion region, the $\gamma$ value is unaffected.

An impurity layer for increasing the bulk concentration in the vicinity of the depletion region is formed in a transistor requiring a high punch-through voltage in order to improve the punch-through voltage characteristic thereof. Also, an impurity layer is formed in such a depth so as to have no effect on the $\gamma$ value in a transistor requiring no high punch-through voltage so that the operating voltage is not affected by the back bias.

Embodiments of the present invention will now be described, by way of example, with reference to the accompanying drawings, in which:

FIG. 1 is a cross-sectional view of the CMOS manufactured according to the conventional method;
FIGS. 2A-2B are cross-sectional views of the CMOS devices manufactured according to the present invention;
FIGS. 2C-2F are cross-sectional views of CMOS devices not being part of the invention;
FIGS. 3A-3F are cross-sectional views for explaining the method for manufacturing the CMOS according to the first embodiment of the present invention; and
FIGS. 4A-4F are cross-sectional views for explaining the method for manufacturing the CMOS according to the second embodiment of the present invention.

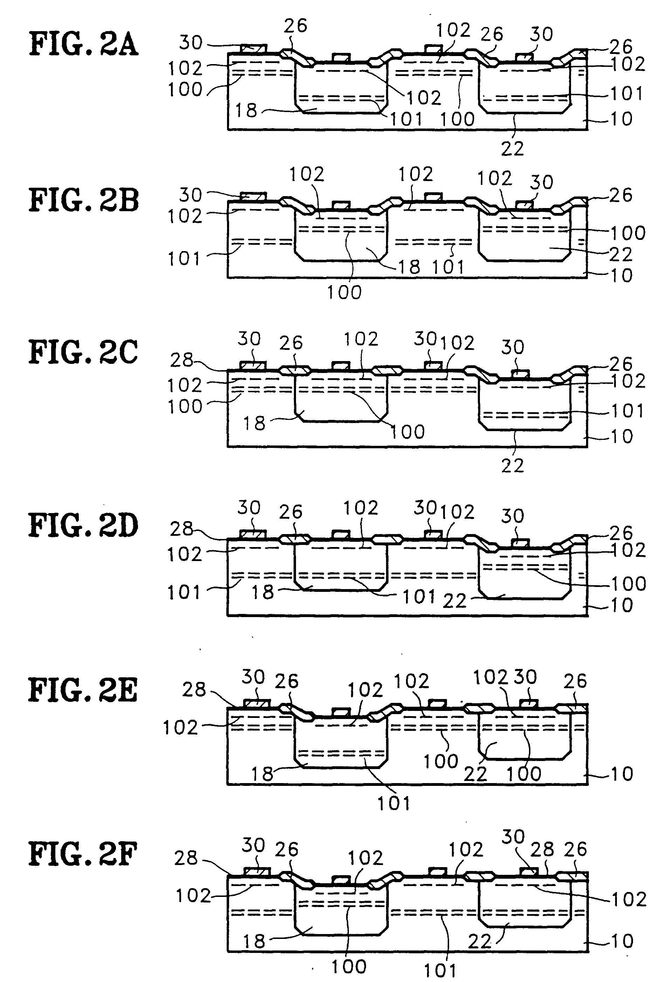

In FIGS. 2A-2F, reference numeral 10 is a semiconductor substrate, reference numeral 18 is an N-well, reference numeral 22 is a P-well, reference numeral 26 is a field oxide layer, reference numeral 28 is a gate oxide layer, reference numeral 30 is a gate electrode, reference numeral 100 is a first impurity layer, reference numeral 101 is a second impurity layer, and reference numeral 102 is a third impurity layer.

FIG.2A is a cross-sectional view of the CMOS manufactured according to a first embodiment of the present invention.

A first impurity layer 100 is formed in the vicinity of the depletion region of the transistor formed in the region (to be called "a third region" hereinafter) where a well is not formed. A second impurity layer 101 deeper than the first impurity layer 100 with respect to the surface of the semiconductor substrate, is formed on N-well 18 (formed on a first region) and P-well 22 (formed on a second region). Also, a third impurity layer 102 is formed in the channel region of each transistor in order to control the threshold voltage thereof.

At this time, the first and second impurity layers 100 and 101 each have a concentration lower than the third impurity layer 102 but higher than substrate 10 and wells 18 and 22.

For example, in the present invention, the concentration of the first and second impurity layers 100 and 101 is in the range of 1.0~5.0E11 ions/cm$^2$. The first impurity layer 100 is positioned as deeply as the depletion region is formed, for example, about 0.8-1.5$\mu$m from the surface of the semiconductor substrate.

From FIG. 2A, it is understood that first impurity layer 100 can increase the punch-through voltage of the transistor of the third-region, in which a high punch-through voltage is required.

FIG. 2B is a cross-sectional view of the CMOS manufactured according to the second embodiment of the present invention, from which it is understood that the punch-through voltage characteristics of the transistors to be formed on the first region (N-well) 18 and second region (P-well) 22 are improved, differently from the first embodiment. Also, the first impurity layer 100 is formed in N well 18 and P well 22, and the second impurity layer 101 is formed in the third region.

FIGS. 2C to 2F are cross-sectional views of CMOS devices not being part of the invention. Here, the CMOS of FIG. 2C is for improving punch-through voltage characteristics of the transistor to be formed on the N-well 18 and the third region, the CMOS of FIG. 2D is for improving punch-through voltage characteristics of the transistor to be formed on the P-well 22, the CMOS of FIG. 2E is for improving punch-through voltage characteristics of the transistor to be formed on the P-well 22 and the third region, and the CMOS of FIG. 2F is for improving punch-through voltage characteristics of the transistor to be formed on the N-well 18.

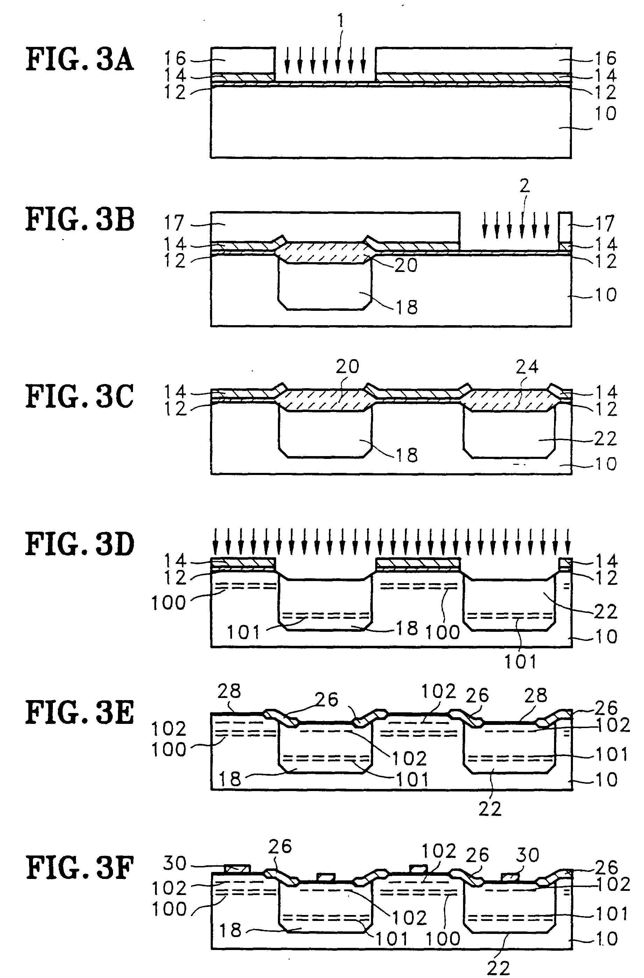

FIGS. 3A to 3F are cross-sectional views for explaining a method for manufacturing the CMOS according to the first embodiment of the present invention.

First, FIG. 3A shows a process of doping the impurity to form an N-well 18 and the process is proceeded by a first step of forming a pad oxide layer 12 and first insulating layer 14 sequentially on a semiconductor substrate 10, a second step of forming a first window 1 by performing a conventional photolithographic etching process after forming a photosensitive layer 16, e.g., a photoresist on the first insulating layer 14, and a third step of doping impurities through the first window 1.

At this time, the semiconductor substrate 10 has a specific resistance of 18$\Omega$/cm and is doped with P-type impurities. The pad oxide layer 12 is used as a buffer oxide layer and is formed with a thickness of 500Å~1,000Å (1Å = 10$^{-10}$ m). The first insulating layer 14 is a nitride layer and is formed with a thickness of 1,000Å~2,000Å, which is not limited as such but is adjusted by the doping energy of impurities and depth of the depletion region. The impurities are implanted using phosphorous ions at an energy of about 100keV and a concentration of 1.8E13 ions/cm$^2$.

FIG. 3B shows a process of completing N-well 18 and doping the impurity to form P-well and the process is preceeded by a first step of forming a second insulating layer 20 on the first region and at the same time completing the N-well 18 by performing a well drive-in process, a second step of forming a second window 2 by removing the first insulating layer in the region (second region) for a P-well to be formed thereon by performing an etching process after forming a photosensitive layer 17 for forming the P-well on the whole surface of the resultant structure, and a third step of doping impurities through the second window 2.

At this time, the second insulating layer 20 is formed with a thickness of 4,000Å~6,000Å. The drive-in process is performed at 1150°C for about eight hours. Also, the impurities doped through the second window 2 are boron (B) ions and are implanted at an energy of about 80keV and a concentration of 2.1E12 ions/cm$^2$.

FIG. 3C shows a process of completing P-well 22 and the process is proceeded such that a third insulating layer 24 is formed on the region where the impurities are doped for forming P-well and at the same time the impurities are diffused by performing a well drive-in process to complete the P-well 22.

At this time, the drive-in process is performed at 1150°C for about eight hours.

As shown in FIGS. 3A to 3C, the N-well and P-well may be formed by respectively performing an ion-implanting process, oxidation process and drive-in processes of the N-well and the P-well with respect thereto. However, after separately performing only the ion-implanting process, the drive-in process can proceed at the same time. When a pocket P-well is to be formed, the second insulating layer is removed after the N-well drive-in process and then the ion-implanting process is performed for forming P-well, so that the pocket P-well may be formed.

FIG. 3D shows a process of forming first and second impurity layers 100 and 101 and the process is proceeded by a first step of removing second and third insulating layers on the respective wells and a second step of doping impurities on the whole surface of the resultant structure.

Referring to FIG. 3D, the first impurity layer 100 is formed to be higher than the second impurity layer 101. This makes the energy of the impurities implanted with the same energy be reduced in the substrate region by the pad oxide layer and first insulating layer so that the first impurity layer becomes high.

In the second step, the impurities are ion-implanted at an energy of about 400keV~800keV. The first impurity layer 100 is formed to a depth in which the depletion region is formed, i.e., about 0.8μm~1.5μm into the surface of the semiconductor substrate.

At this time, it is suitable that the concentration of impurities implanted for forming the first and second impurity layers is lower than an ion-implanting dosage for adjusting a threshold voltage and is higher than that of the substrate. In the present invention, the concentration corresponds to a dosage of 1.0~5.0E11 ions/cm$^2$.

FIG. 3E shows a process of forming a third impurity layer 102 for adjusting a threshold voltage and the process is proceeded by a first step of removing the pad oxide layer and first insulating layer remaining on the semiconductor substrate 10, a second step of forming a field oxide layer 26 to separate the respective well units, a third step of forming the third impurity layer 102 by doping impurities on the whole surface of the resultant structure for adjusting a threshold voltage, and a fourth step of forming a gate oxide layer 28 on the respective well and substrate.

At this time, the impurity-implantation is carried out with boron ions at an energy of about 30keV and a dosage of about 1.7E12 ions/cm$^2$. The gate oxide layer 28 is formed with a thickness of about 120Å. Of course, the thickness of gate oxide layer 28 is varied depending on the application of transistor.

FIG. 3F shows a process of forming a gate electrode 30, which proceeds conventionally.

According to the first embodiment of the present invention, the depths of the first and second impurity layers 100 and 101 of the substrate are made to be different from each other. For the substrate, the first impurity layer is formed in the source and drain depletion regions of a transistor. For the well, the second impurity layer is formed under the source and drain depletion regions of a transistor.

Therefore, the transistor formed on the substrate can obtain a high punch-through voltage and the transistor formed on the well can obtain an operating voltage which is not affected by the bulk concentration of the high-concentration impurity layer, thereby selectively obtaining a high punch-through voltage without a separate mask.

Also, the third impurity layer 102 for adjusting a threshold voltage is formed so that the threshold voltages of the respective transistors can be adjusted easily.

Throughout the drawings discussed hereinafter, like elements are designated by the same reference numerals as in FIGS. 3A to 3F.

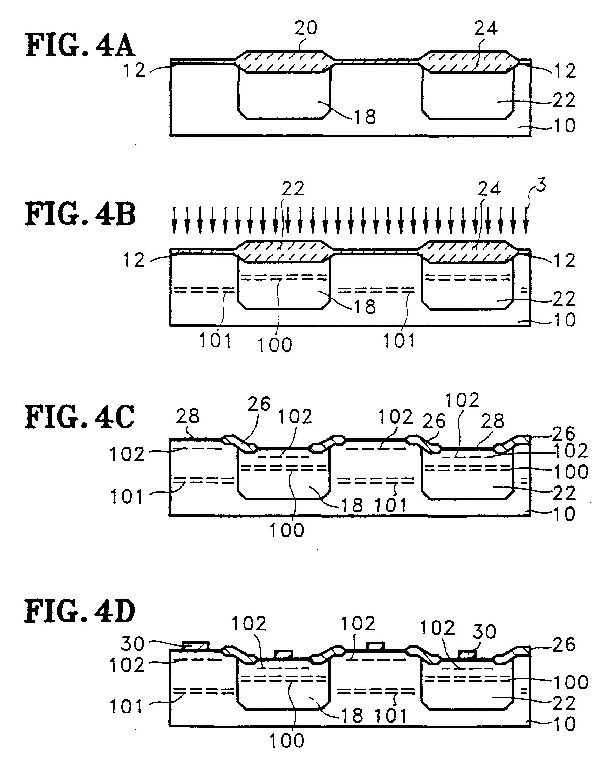

FIGS. 4A to 4D are cross-sectional views for explaining a method for manufacturing the CMOS according to the second embodiment of the present invention, which is for increasing the punch-through voltage of a transistor formed on wells 18 and 22, while the first embodiment was for increasing the punch-through voltage of a transistor formed on substrate 10. The method of the second embodiment differs from that of the first only in that, here, first and second impurity layers 100 and 101 are formed by doping impurities after removing the first insulating layer (FIG. 4A), differently from the case of the first embodiment where first and second impurity layers are formed by doping impurities after removing the second and third insulating layers.

**Claims**

1. A method of manufacturing a CMOS device comprising the steps of, sequentially:

    (a) forming a first insulating layer (14) on a semiconductor substrate (10);
    (b) removing said first insulating layer (14) from a region for a first well (18) to be formed thereon;
    (c) doping impurities into said region to form the first well (18);
    (d) forming a second insulating layer (20) on the surface of the region from which said first insulating layer (14) has been removed and completing the first well (18) under said second insulating layer (20) by performing a well drive-in process;

(e) removing said first insulating layer (14) from a second region for a second well (22) to be formed thereon;

(f) doping impurities into said second region to form said second well (22);

(g) forming a third insulating layer (24) on the surface of the region from which said first insulating layer (14) has been removed to form the second well (22), and completing the second well (22) under said third insulating layer (24) by performing a well drive-in process;

(h) removing either of said first insulating layer (14) or said second and third insulating layers (20, 24); and,

(i) forming a first impurity layer (100) at a first depth in the region from which said insulating layer or layers is or are not removed by step (h) and a second impurity layer (101) at a second depth larger than said first depth, in the region from which said insulating layer or layers is or are removed by step (h), by implanting impurities in the whole surface of the resultant structure,

(j) forming MOS transistors in the region from which said insulating layer or layers is or are not removed by step (h) and in the region from which said insulating layer or layers is or are removed by step (h), said first impurity region lying in the source/drain depletion regions of the transistors, thereby increasing the punch-through voltage thereof,

said second impurity region lying under the source/drain depletion regions of the transistors, thereby not affecting the operating voltage thereof.

2.  A method of manufacturing a CMOS device as claimed in claim 1, which, after said step (i), further comprises the step of redoping impurities in the depth less than said first impurity layer (100) in the whole surface of the resultant structure, thereby forming a third impurity layer (102).

3.  A method of manufacturing a CMOS device as claimed in claim 2, wherein the concentration of said first and second impurity layers (100, 101) is lower than that of said third impurity layer (102) and is higher than that of said semiconductor substrate (10) and wells (18, 22).

4.  A method of manufacturing a CMOS device as claimed in any of claims 1 to 3, wherein said first insulating layer (14) is formed in the thickness of 1,000Å~2,000Å and said second insulating layer (20) is formed in the thickness of 4,000Å~6,000Å.

5.  A method of manufacturing a CMOS device as claimed in any of claims 1 to 4, wherein in said step (i), said impurities are doped at an energy of 400keV~800keV.

6.  A method of manufacturing a CMOS device as claimed in any of claims 1 to 5, wherein said second well is formed within said first well.

7.  A method of manufacturing a CMOS device as claimed in any of claims 1 to 6, wherein said first well (18) is an N-impurity doped well and said second well (22) is a P-impurity doped well.

**Revendications**

1.  Procédé de fabrication d'un dispositif CMOS comprenant les étapes consistant à, en séquence :

(a) former une première couche d'isolation (14) sur un substrat semiconducteur (10) ;
(b) enlever ladite première couche d'isolation (14) d'une région sur laquelle doit être formé un premier puits (18) ;
(c) doper des impuretés dans ladite région pour former le premier puits (18) ;
(d) former une deuxième couche d'isolation (20) sur la surface de la région dont ladite première couche d'isolation (14) a été enlevée et terminer le premier puits (18) sous ladite deuxième couche d'isolation (20) en exécutant un processus de réinjection de puits ;
(e) enlever ladite première couche d'isolation (14) d'une deuxième région sur laquelle doit être formé un deuxième puits (22) ;
(f) doper des impuretés dans ladite deuxième région pour former ledit deuxième puits (22) ;
(g) former une troisième couche d'isolation (24) sur la surface de la région dont ladite première couche d'isolation (14) a été enlevée pour former le deuxième puits (22) et terminer le deuxième puits (22) sous ladite troisième couche d'isolation (24) en exécutant un processus de réinjection de puits ;
(h) enlever, soit ladite première couche d'isolation (14), soit lesdites deuxième et troisième couches d'isolation (20, 24) ; et
(i) former une première couche d'impuretés (100) à une première profondeur dans la région dont ladite couche ou lesdites couches d'isolation n'est pas ou ne sont pas enlevées par l'étape (h) et une deuxième couche d'impuretés (101) à une deuxième profondeur plus grande que ladite première profondeur, dans la région d'où ladite couche ou lesdites couches d'isolation est ou sont enlevées par l'étape (h), en implantant des impuretés dans toute la surface de la structure résultante,

(j) former des transistors MOS dans la région dont ladite couche ou lesdites couches d'isolation n'est pas ou ne sont pas enlevées par l'étape (h) et dans la région dont ladite couche ou lesdites couches d'isolation est ou sont enlevées par l'étape (h), ladite première région d'impuretés se trouvant dans les régions d'appauvrissement de source/drain des transistors, de façon à augmenter leur tension de percement,

ladite deuxième région d'impuretés se trouvant sous les régions d'appauvrissement de source/drain des transistors, de manière à ne pas modifier leur tension de fonctionnement.

2. Procédé de fabrication d'un dispositif CMOS selon la revendication 1, qui, après ladite étape (i), comprend en outre l'étape consistant à doper de nouveau des impuretés sur une profondeur inférieure à ladite première couche d'impuretés (100) dans toute la surface de la structure résultante, de manière à former une troisième couche d'impuretés (102).

3. Procédé de fabrication d'un dispositif CMOS selon la revendication 2, dans lequel la concentration desdites première et deuxième couches d'impuretés (100, 101) est inférieure à celle de ladite troisième couche d'impuretés (102) et est supérieure à celle dudit substrat semiconducteur (10) et des puits (18, 22).

4. Procédé de fabrication d'un dispositif CMOS selon l'une quelconque des revendications 1 à 3, dans lequel ladite première couche d'isolation (14) est formée sur une épaisseur de 1 000 Å à 2 000 Å et ladite deuxième couche d'isolation (20) est formée sur une épaisseur de 4 000 Å à 6 000 Å.

5. Procédé de fabrication d'un dispositif CMOS selon l'une quelconque des revendications 1 à 4, dans lequel dans ladite étape (i), lesdites impuretés sont dopées avec une énergie de 400 keV à 800 keV.

6. Procédé de fabrication d'un dispositif CMOS selon l'une quelconque des revendications 1 à 5, dans lequel ledit deuxième puits est formé à l'intérieur dudit premier puits.

7. Procédé de fabrication d'un dispositif CMOS selon l'une quelconque des revendications 1 à 6, dans lequel ledit premier puits (18) est un puits dopé par des impuretés n et ledit deuxième puits (22) est un puits dopé par des impuretés p.

**Patentansprüche**

1. Verfahren zur Herstellung einer CMOS-Vorrichtung umfassend nacheinander die Schritte:

(a) Ausbilden einer ersten Isolierschicht (14) auf einem Halbleitersubstrat (10),
(b) Entfernen der ersten Isolierschicht (14) von einer Region, damit eine erste Quelle (18) darauf ausgebildet werden kann,
(c) Dotieren von Fremdstoffen in die Region, um die erste Quelle (18) auszubilden,
(d) Ausbilden einer zweiten Isolierschicht (20) auf der Oberfläche der Region, von der die erste Isolierschicht (14) entfernt wurde und Fertigstellen der ersten Quelle (18) unter der zweiten Isolierschicht (20) durch Ausführen eines Quelleneinführprozesses,
(e) Entfernen der ersten Isolierschicht (14) von einer zweiten Region, damit eine zweite Quelle (22) darauf ausgebildet werden kann,
(f) Dotieren von Fremdstoffen in die zweite Region, um die zweite Quelle (22) auszubilden,
(g) Ausbilden einer dritten Isolierschicht (24) auf der Oberfläche der Region, von der die erste Isolierschicht (14) entfernt wurde, um die zweite Quelle (22) auszubilden, und Fertigstellen der zweiten Quelle (22) unter der dritten Isolierschicht (24) durch Ausführen eines Quelleneinführprozesses,
(h) Entfernen entweder der ersten Isolierschicht (14) oder der zweiten und dritten Isolierschicht (20, 24), und
(i) Ausbilden einer ersten Fremdstoffschicht (100) in einer ersten Tiefe in der Region, von der die Isolierschicht oder -schichten in Schritt (h) nicht entfernt wurde oder wurden, und einer zweiten Fremdstoffschicht (101) in einer zweiten Tiefe, die grösser ist als die erste Tiefe, in der Region, von der die Isolierschicht oder -schichten in Schritt (h) entfernt wurde oder wurden, wobei Fremdstoffe in die gesamte Oberfläche der erhaltenen Struktur implantiert werden,
(j) Ausbilden von MOS-Transistoren in der Region, von der die Isolierschicht oder -schichten in Schritt (h) nicht entfernt wurde oder wurden, und in der Region, von der die Isolierschicht oder -schichten in Schritt (h) entfernt wurde oder wurden, wobei die erste Fremdstoffregion in den Source/Drainsperrschichten der Transistoren liegen, wodurch deren Durchgreifspannung erhöht wird,

wobei die zweite Fremdstoffregion unter den Source/Drainsperrschichten der Transistoren liegen, wodurch deren Betriebsspannung nicht beeinflusst wird.

**2.** Verfahren zur Herstellung einer CMOS-Vorrichtung nach Anspruch 1, die nach Schritt (i) ferner den Schritt eines erneuten Dotierens mit Fremdstoffen umfasst, in einer geringeren Tiefe als die erste Fremdstoffschicht (100) in der gesamten Oberfläche der erhaltenen Struktur, wodurch eine dritte Fremdstoffschicht (102) ausgebildet wird.

**3.** Verfahren zur Herstellung einer CMOS-Vorrichtung nach Anspruch 2, worin die Konzentration der ersten und zweiten Fremdstoffschicht (100, 101) geringer ist als die der dritten Fremdstoffschicht (102) und höher ist als die des Halbleitersubstrats (10) und der Quellen (18, 22).

**4.** Verfahren zur Herstellung einer CMOS-Vorrichtung nach einem der Ansprüche 1 bis 3, worin die erste Isolierschicht (14) in einer Dicke von 1000 Å-2000 Å ausgebildet ist und die zweite Isolierschicht (20) in einer Dicke von 4000 Å-6000 Å ausgebildet ist.

**5.** Verfahren zur Herstellung einer CMOS-Vorrichtung nach einem der Ansprüche 1 bis 4, worin im Schritt (i) die Fremdstoffe mit einer Energie von 400 keV-800 keV dotiert werden.

**6.** Verfahren zur Herstellung einer CMOS-Vorrichtung nach einem der Ansprüche 1 bis 5, worin die zweite Quelle in der ersten Quelle ausgebildet wird.

**7.** Verfahren zur Herstellung einer CMOS-Vorrichtung nach einem der Ansprüche 1 bis 6, worin die erste Quelle (18) eine mit N-Fremdstoff dotierte Quelle ist und die zweite Quelle (22) eine mit P-Fremdstoff dotierte Quelle ist.

# FIG. 1 (PRIOR ART)

EP 0 683 515 B1

FIG. 2A

FIG. 2B

FIG. 2C

FIG. 2D

FIG. 2E

FIG. 2F

EP 0 683 515 B1

**FIG. 3A**

16  1
14
12
10
16
14
12

**FIG. 3B**

17  2
14
12
20
18
17
14
12
10

**FIG. 3C**

14  20  24
12
18  22
10
14
12

**FIG. 3D**

14
12
100
101  18  100
14
12
22
10
101

**FIG. 3E**

28  26  102  26  28
102  26
100  102
18  101  22
101
102
10

**FIG. 3F**

30  26  102 26  30
102  26
100  102
18  101  100  22
102
101
10

11

**FIG. 4A**

**FIG. 4B**

**FIG. 4C**

**FIG. 4D**